(19) **Europäisches Patentamt** / **European Patent Office** / **Office européen des brevets**

(11) **EP 4 302 340 B1**

(12) **EUROPEAN PATENT SPECIFICATION**

(45) Date of publication and mention of the grant of the patent:
**13.05.2026 Bulletin 2026/20**

(21) Application number: **21709388.9**

(22) Date of filing: **01.03.2021**

(51) International Patent Classification (IPC):
**B41J 2/155** (2006.01) **B41J 2/21** (2006.01)
**H10K 71/13** (2023.01)

(52) Cooperative Patent Classification (CPC):
**B41J 2/155; B41J 2/2139; B41J 2/2142;**
**H10K 71/135;** B41J 2202/19; B41J 2202/20

(86) International application number:
**PCT/EP2021/055055**

(87) International publication number:
**WO 2022/184229 (09.09.2022 Gazette 2022/36)**

(54) **APPARATUS AND METHOD FOR PRINTING ON A SUBSTRATE FOR DISPLAY MANUFACTURE**

VORRICHTUNG UND VERFAHREN ZUM DRUCKEN AUF EINEM SUBSTRAT ZUR HERSTELLUNG EINES DISPLAYS

APPAREIL ET PROCÉDÉ D'IMPRESSION SUR UN SUBSTRAT POUR LA FABRICATION D'UN DISPOSITIF D'AFFICHAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**10.01.2024 Bulletin 2024/02**

(73) Proprietor: **Applied Materials, Inc.**
**Santa Clara, California 95054 (US)**

(72) Inventors:
• **CELLERE, Giorgio**
  **36040 Torri di Quartesolo (IT)**
• **FURIN, Valentina**
  **31100 Treviso (IT)**

• **NG, Hou T.**
  **Campbell, California 95008 (US)**
• **MACCARI, Andrea**
  **31020 Villorba (TV) (IT)**
• **ROSSI, Pierluigi**
  **31020 Villorba (TV) (IT)**

(74) Representative: **Zimmermann & Partner**
**Patentanwälte mbB**
**Postfach 330 920**
**80069 München (DE)**

(56) References cited:
**US-A1- 2003 189 604    US-A1- 2013 177 698**
**US-A1- 2015 298 153    US-A1- 2020 365 566**

## Description

## TECHNICAL FIELD

Embodiments of the present invention relate to an apparatus and method for printing on a substrate for display manufacture, particularly a substrate for the manufacture of micro LED-based displays, particularly displays including quantum dot-based dyes. Embodiments of the present invention particularly relate to an apparatus and a method to perform a printing operation and a reworking operation on a substrate along a common axis. Further embodiments relate to an apparatus having a print head and a print bar for printing on a substrate for display manufacture.

## BACKGROUND

In display manufacture, several techniques are known to provide displays with improved resolution and contrast characteristics, and many approaches have been developed. Where LCDs (liquid crystal displays) use light-modulating properties of liquid crystals for influencing light provided by a backlight source or reflector to produce images in color or monochrome, the technique of OLED (organic light-emitting diode) displays provides organic materials directly emitting visible light in response to an electric power.

OLED displays are known to have beneficial effects in contrast to LCDs, for example, thinner and lighter displays can be provided, the OLED displays achieve deeper black levels and a higher contrast ratio as well as are flexible and transparent, thus allowing the use of OLED displays in multiple applications such as screens, TVs, smartphones, etc.

The generation of OLED substrates is typically carried out by coating an organic material onto a substrate, the organic material providing the primary colors red, blue and green to generate pixels on the substrate. The coating processes can be, e.g., based on the evaporation of organic materials, e.g., a host material and dopant materials, being deposited on the substrate, to provide for the differently colored pixels on the substrate.

In contrast to the OLED technology, micro LEDs (light-emitting diodes) can provide microscopically small pixels on a substrate, the micro LEDs being made of inorganic materials, e.g., indium gallium nitride (InGaN), provided as semiconductor arrays, the micro LEDs being capable of self-emitting light in response to an electric power. The micro LED technology can be beneficial compared to the OLED technology regarding display manufacture as regards to, e.g., lifetime, brightness and contrast of the resulting displays. So far, the manufacture of micro LED arrays suitable for display manufacture has been expensive and inefficient. Furthermore, the provision of colored pixels is challenging.

An approach to providing colored pixels in micro LED based displays is the use of fluorescent dyes which are excited by light emitted from a micro LED and as a result emit a specific radiation pattern, such as a band of wavelengths corresponding to the colors red, green and blue. Quantum dot dyes can be suitable for this purpose. The dyes are typically applied to specific locations of the substrate corresponding to the location of a micro LED by a printing process. A suitable printing process for providing the dyes onto a substrate can be a limiting factor in achieving a cost and time effective manufacturing of high-quality displays.

Document US 2003/189604 A1 describes a device for fabricating a display panel having ink-jet printing applied thereto, including a stage for supporting a substrate, a base having one or more than one rail for transporting the stage, and one or more than one ink-jet head rotatable by an angel for spraying a pattern forming solution to the substrate.

Document US 2013/177698 A1 describes a method for inspection aided printing. The method includes printing, by a printing unit of a system, a pattern on an area of a substrate, during a printing process, inspecting, by an inspection unit of the system, the area to provide inspection results, and searching, by a processor of the system, for a defect, based upon the inspection results.

In light of the above, it is beneficial to provide an improved apparatus or method for printing on substrates for display manufacture.

## SUMMARY

The invention is set out in the appended set of claims.

According to an aspect, an apparatus for printing on a substrate for display manufacture is provided. The apparatus includes an alignment station for aligning the substrate, a print station for printing on the substrate and an inspection station for inspecting the printed substrate for defects. The alignment station, the print station and the inspection station are provided along a common axis. The common axis is configured for moving the substrate from the alignment station to the print station and from the print station to the inspection station. The common axis is further configured for moving the printed substrate, under the condition that a defect is detected in the inspection station, from the inspection station back to the print station, the print station being configured for reworking the printed substrate to correct the detected defect by again printing on the substrate.

According to a further aspect, a method for printing on a substrate for display manufacture is provided. The method includes loading the substrate into a loading position provided along a common axis, moving the substrate along the common axis from the loading position to an alignment station provided along the common axis, aligning the substrate, moving the substrate along the common axis from the alignment station to a print station provided along the common axis, printing on the substrate, moving the printed substrate along the common axis from the print station to an inspection station provided along the common axis, and inspecting the printed substrate. The method further includes, under the condition that a defect is detected on the printed substrate, performing the following four operations: moving the defective printed substrate back along the common axis from the inspection station to the print station, reworking the defective printed substrate to correct the detected defect by again printing on the substrate in the print station, moving the defective printed substrate along the common axis from the print station to the inspection station, and inspecting the reworked printed substrate. Under the condition that no defect is detected on the printed substrate, the method includes moving the printed substrate along the common axis from the inspection station for further processing.

Printing as described herein, such as the printing of the print station of an apparatus described herein, or the printing operation according to a method described herein, can include the printing of an ink on a substrate. The ink can be a UV ink, such as an ink including a fluorophore, such as an ink including quantum dot dyes. UV ink, in this context, can be defined by an absorption of the ink at a wavelength or a band of wavelengths below 500 nm, such as in a range of 350 nm to 480 nm, below 450 nm, or in a range of 385 nm to 400 nm. The UV ink can be excitable by absorbing light and emit a higher wavelength fluorescence. The printing can include applying the ink onto predefined locations on the substrate. The predefined locations on the substrate can correspond to the location of a micro LED or a number of micro LEDs.

The ink can be applied such that the ink is illuminated by a single micro LED or a specific or defined selection of a number of micro LEDs, and not illuminated by other micro LEDs. According to one example, the ink can be supplied in the form of droplets onto the substrate to form an ink spot. The ink spot can be illuminated by a micro LED provided on the location of the ink spot, such that operating the micro LED specifically illuminates the ink spot but does not illuminate other ink spots. The ink spot can be limited in size, e.g. according to the size of the micro LED or the area of illumination provided by the micro LED when the micro LED is operated, e.g. such that the ink spot is not illuminated by other micro LEDs.

The ink, such as an ink spot resulting from applying a droplet of the ink onto the substrate, can form a component of a pixel of a display device. For example, a pixel can comprise four adjacent ink spots to be each separately illuminated by four separate micro LEDs, e.g., one ink spot provides red light, two ink spots provide green light, and one ink spot provides blue light when illuminated by the corresponding micro LED. In the example, the pixel can comprise the ink spots and corresponding micro LEDs arranged in a 2x2 pattern. Other pixel arrangements than the one described above can be equally suitable.

Printing can include ink jet printing, i.e., the use of an ink jet print head and/or an ink jet print method. Ink jet printing can include dispensing an ink from a number of nozzles provided in a print head, such that a droplet of ink or a sequence of droplets of ink is applied to a surface opposite the nozzle, such as the substrate described herein. In some examples, ink jet printing can include providing a number of smaller droplets to the same location. Ink jet printing is typically performed by moving a substrate to be printed relative to the print head, and by operating the nozzles in a timed fashion such that the ink is dispensed onto the desired location.

The substrate can be a glass substrate or a polymer substrate, particularly a substrate for display manufacture. The substrate can have a size ranging between 160 mm x 120 mm up to 640 mm x 480 mm, such as 320 mm x 240 mm, or sizes above or below the given ranges. The substrate can be rectangular, or differently shaped. The substrate can be quadratic, circular, hexagonal, or a collection of smaller substrates provided on a larger carrier substrate. The substrate can have a thickness of 0.1 mm to 1 mm, such as 0.5 mm.

The substrate can include structural features to aid in the specific application of the ink to the desired location. Such features can include surface modifications of the substrate to prevent the spread of the ink across the desired boundaries, e.g., the spread of ink across the desired, limited size of an ink spot. The modifications of the substrate can further prevent the undesired mixing of the ink, e.g., when a first droplet or ink spot comes into contact with a second droplet or ink spot. Possible surface modifications can include providing a patterned substrate, such as a substrate with a patterned surface. Patterning of the substrate can include providing a pattern on the surface of the substrate receiving the ink, for example indentations within the substrate according to the desired pixel structure, i.e., the desired location of the ink spot. The substrate modifications can be provided in the form of micro wells within the substrate surface to receive the printed or dispensed ink, e.g., a droplet of dispensed ink, and hold the ink therein, particularly until the ink is cured. Other types of structures, such as barriers, particularly enclosures formed by hydrophilic barriers (e.g. for hydrophobic inks) or hydrophobic barriers (e.g. for water-based inks) on the substrate surface for preventing the spread of the ink across the barrier, can be equally suitable. In a beneficial embodiment, the surface modifications of the substrate increase the spatial tolerance for applying the ink droplet therein, e.g., the ink droplet can be provided at any position within a well or other feature included in the pattern provided by the surface modification on the substrate, and the ink can then spread, e.g., within the well, to result in a desired, uniform ink spot.

Despite recent advances in increasing the accuracy and reproducibility of printing methods, particularly ink jet printing methods, and the utilization of advanced surface structure described above, the high number and small size of structures, such as pixels, used in the manufacture of modern display devices can, in some cases, lead to errors during a printing process resulting in a number of defects of the printed substrates. Possible defects can include the missing, uneven or incomplete application of ink, a mixing of two ink spots, the application of an ink spot to an undesired location, or the like. To avoid having to discard such defective substrates, the defective substrates can be reworked to correct said defects, which can result in a correctly printed substrate. Reworking can include the application of ink to locations having missing ink spots. Reworking can include the cleaning and/or bleaching of the ink on specific locations of the substrate, and the application of ink to the cleaned and/or bleached locations.

Known reworking methods for the reworking of a printed substrate, particularly for the reworking of printed substrates for display manufacture, can be complicated or time consuming, often requiring additional machinery and manual interaction with the printed substrate, such as unloading the substrate from the main printing line and loading the substrate into a reworking station.

In light of the above, it can be desirable to provide an apparatus according to embodiments described herein for printing on a substrate and further for performing a reworking of a printed substrate, and a method according to embodiments described herein including operations for printing and reworking a printed substrate.

BRIEF DESCRIPTION OF THE DRAWINGS

So that the manner in which the above recited features can be understood in detail, a more particular description, briefly summarized above, may be had by reference to embodiments. The accompanying drawings relate to embodiments and are described in the following:

Fig. 1        shows a schematic side view of a first embodiment of a printing apparatus;
Fig. 2        shows a schematic side view of a second embodiment of a printing apparatus;
Fig. 3        shows a method for printing on a substrate according to an embodiment;
Fig. 4A      shows a conventional print head;
Fig. 4B      shows a print head according to an embodiment described herein; and
Figs. 5A to 5D  show examples of print bars according to embodiments described herein.

DETAILED DESCRIPTION OF EMBODIMENTS

Reference will now be made in detail to the various embodiments, one or more examples of which are illustrated in the figures. Within the following description of the drawings, the same reference numbers refer to same components. Generally, only the differences with respect to individual embodiments are described. Each example is provided by way of explanation and is not meant as a limitation. Further, features illustrated or described as part of one embodiment can be used on or in conjunction with other embodiments to yield yet a further embodiment. It is intended that the description includes such modifications and variations.

In this disclosure, reference is made to embodiments including a substrate. The substrate can be described in terms of attributes assigned thereto, such as "printed substrate", "defective substrate", or "reworked substrate", which are intended to help in understanding the disclosure and are in no way to be understood as a limitation.

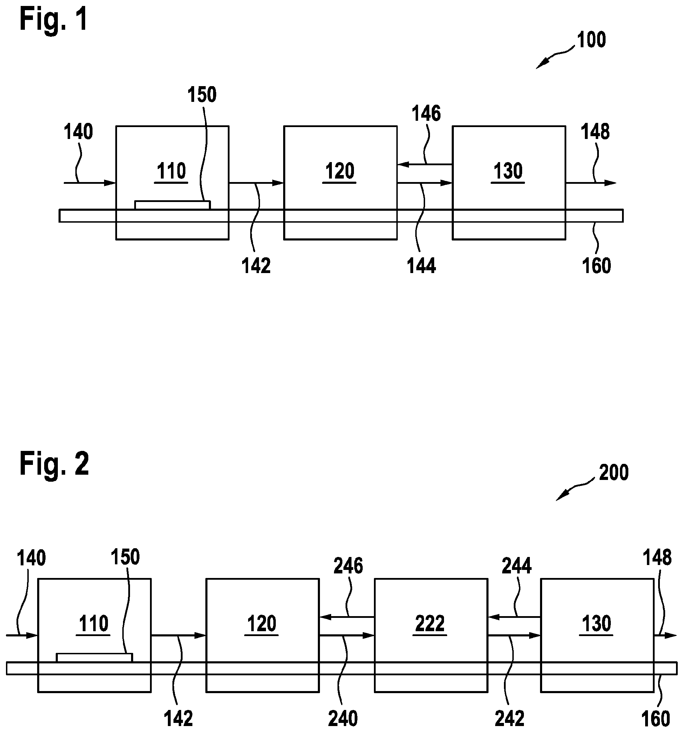

Fig. 1 shows an apparatus 100 for printing on a substrate 150 for display manufacture according to an embodiment. The apparatus includes an alignment station 110, a print station 120 and an inspection station 130. The stations 110, 120 and 130 are arranged along a common axis 160. According to embodiments, a substrate 150 is provided. The substrate 150 can be provided on or include a substrate assembly, e.g., the substrate can be provided on a substrate holder, or a substrate carrier. According to embodiments, the substrate 150 can be a substrate for being printed on, i.e., the apparatus 100 can be configured for the first-time printing of the substrate 150. According to further embodiments, the substrate can be partially printed, i.e. the apparatus 100 can be configured for performing a printing operation of a sequence of printing operations.

According to embodiments, as shown in Fig. 1, the apparatus 100 can receive a substrate 150 at a substrate entry position and transfer the substrate 150 to the alignment station 110. In Fig. 1, the substrate is shown inside the alignment station 110. According to Fig. 1, the transfer of the substrate to the alignment station 110 is depicted as transfer 140. The transfer of the substrate 150 can be performed by the common axis 160 configured for transferring the substrate.

According to embodiments, the alignment station 110 aligns the substrate 150. Aligning the substrate 150 can include identifying, e.g., by an optical alignment system, a position of the substrate 150. The position of the substrate can be identified relative to the apparatus 100 or components of the apparatus 100, such as the common axis 160, or the print station 120. The identified position of the substrate 150 can include information about a lateral offset of the substrate 150 and/or a rotational offset of the substrate 150. The alignment station 110 can align the substrate 150 according to fiducial markers provided on the substrate 150 and/or the substrate holder, an edge position of the substrate 150 and/or a position of features comprising a pixel structure provided on the substrate 150. The position of features comprising a pixel structure can include surface modifications on the substrate 150, e.g., as described above, the position of micro LEDs.

According to embodiments, aligning the substrate 150 can include performing corrective movements on the substrate 150, e.g., rotating and translating the substrate 150 along one or more axes to bring the substrate 150 into an aligned position. Corrective movements on the substrate 150 can be performed inside the alignment station 110, and/or can be performed in a subsequent station, such as a second alignment station, or other stations, such as the print station 120. Corrective movements can be performed by the substrate holder, e.g. at any point along the common axis 160.

According to embodiments, aligning the substrate 150 can include providing the identified position of the substrate to further components of the apparatus 100, such as the print station 120 and/or the inspection station 130, and performing the operation of the station according to the provided identified position of the substrate 150. In this beneficial example, corrective movements of the substrate 150 can be omitted. According to the embodiment, a possible offset can be corrected by performing an operation, such as printing on the substrate, according to the offset, such as to counteract the offset. According to an example, aligning the substrate 150 in the alignment station 110 can include identifying the position of the substrate 150 and making the identified position of the substrate 150 available to further components of the apparatus 100, such as the print station 120. The print station 120 can, after having received the identified position of the substrate 150, print on the substrate 150 at the desired locations by adjusting a printing location, i.e. the positions for applying an ink, according to the identified position.

According to embodiments, as shown in Fig. 1, the apparatus 100 is configured for transferring the substrate 150 from the alignment station 110 to the print station 120. According to Fig. 1, the transfer of the substrate 150 to the print station 120 is depicted as transfer 142. The transfer of the substrate 150 is performed by the common axis 160 configured for transferring the substrate 150.

According to embodiments, the print station 120 prints on the substrate 150. The operation of the print station 120 can be performed according to embodiments described herein, particularly embodiments as discussed in further detail in relation to the print head, the print bar, the type and application of ink. The substrate 150, after being printed, can be a printed substrate 150.

According to embodiments, as shown in Fig. 1, the apparatus 100 is configured for transferring the substrate 150 from the print station 120 to the inspection station 130. According to Fig. 1, the transfer of the substrate 150 to the inspection station 130 is depicted as transfer 144. The transfer of the substrate 150 is performed by the common axis 160 configured for transferring the substrate 150.

According to embodiments, the inspection station 130 inspects the substrate 150, particularly the printed substrate 150. The inspection station 130 can be an optical inspection system, such as a visual inspection station, such as a camera-based visual inspection system or station. Inspecting the substrate 150 can include detecting defects, particularly printing defects, such as the defects described above, on the substrate 150. The inspection station 130 can perform an operation for detecting defects on the printed substrate 150. According to an example, the inspection station 130 can operate the substrate 150, e.g. by operating a selection of micro LEDs provided on the substrate 150, for detecting if the light emitted by the micro LEDs, and/or detecting whether the dye provided on the substrate 150, such as an ink spot or a plurality of ink spots, particularly the properties of the dye, particularly the absorbed and/or emitted light of the dye, corresponds to desired parameters. According to an example, the inspection station 130 can provide light to the substrate in the absorption wavelength range of the dyes provided on the substrate 150, such as the dyes included in the ink printed on the substrate 150 in the print station 120, and detect if the light emitted by the dye, e.g. at the emission wavelength of the dye, corresponds to desired parameters. According to embodiments, the inspection station can localize defects on the substrate 150, and provide defect data, e.g. including the location and/or type of the defects to further components of the apparatus 100, particularly the print station 120.

According to embodiments, as shown in Fig. 1, the apparatus 100 can be configured for transferring the substrate 150 from the inspection station 130 to a further processing station or an unloading position (not shown). According to Fig. 1, the transfer of the substrate 150 from the inspection station 130 is depicted as transfer 148. The transfer of the substrate 150 can be performed by the common axis 160 configured for transferring the substrate 150. The transfer 148 is conditional, i.e. be performed only when no defects are detected in inspection station 130.

According to embodiments, as shown in Fig. 1, the apparatus 100 is configured for transferring the substrate 150 from the inspection station 130 back to the print station 120. According to Fig. 1, the transfer of the substrate 150 from the inspection station 130 back to the print station 120 is depicted as transfer 146. The transfer of the substrate 150 can be performed by the common axis 160 configured for transferring the substrate 150. The transfer 146 is conditional, i.e. be performed when defects are detected in inspection station 130.

According to embodiments, as shown in Fig. 1, the apparatus 100, particularly the print station 120, is configured for reworking the printed substrate 150 to correct a defect on the substrate, such as a defect detected by the inspection station 130, by again printing on the defective substrate 150, i.e. reprinting or reworking the substrate 150. The print station 120 can be configured for receiving data from other components of the apparatus 100, such as defect data provided by the inspection station 130. The print station 120 can be configured for evaluating the data and performing a printing operation according to the data. In one example, if a defective location is detected on the printed substrate 150, the defective substrate 150 is moved to the print station 120 and the defect is corrected by dispensing ink onto the defective location to correct the defect. According to embodiments, following the reworking in the print station 120, the reworked substrate 150 can again be transferred to the inspection station 130 for inspection by repeating the operations such as described above.

According to embodiments, the substrate can have a number of redundant micro LEDs provided thereon. If a defect is detected, reprinting or reworking the substrate as described above can include printing, with the print station 120, an ink onto a predefined location corresponding to the location of a redundant micro LED. In one example, a redundant micro LED can be provided adjacent to a faulty micro LED. If a defect is detected that is based on the faulty micro LED, the redundant LED can be utilized to substitute the function of the faulty micro LED. Thus, it should be understood that the reworking of a defective substrate is not limited to the reworking of defectively printed substrates.

According to embodiments, as shown in Fig. 1, the apparatus 100 includes a common axis 160. The common axis is configured for moving the substrate 150 from the alignment station 110 to the print station 120 and from the print station 120 to the inspection station 130. The common axis 160 is further configured for moving the printed substrate 150, under the condition that a defect is detected in the inspection station 130, from the inspection station 130 back to the print station 120.

According to embodiments, the common axis 160 is configured for maintaining a defined location of the substrate 150, particularly when moving the substrate 150 according to the operations described above. The defined location of the substrate 150 can be defined as not exceeding a deviation from the expected location of the substrate 150. The defined location can be defined to not exceed a positional deviation of the substrate which is above the smallest feature size of the substrate 150, such as a pixel, a well, or the size or spacing of a micro LED or a selection of micro LEDs. The maximum positional deviation can be in the range of 200 $\mu$m, 100 $\mu$m, 50 $\mu$m, particularly in the range of 40 $\mu$m to 60 $\mu$m, or in the range of 20 $\mu$m to 40 $\mu$m, or 5 $\mu$m to 20 $\mu$m, or 1 $\mu$m to 10 $\mu$m. The common axis 160 can be configured for transferring the substrate 150 across desired positions of the substrate 150 within the apparatus 100. The common axis 160 can affect the movement of, i.e. move, the substrate within or across stations of the apparatus 100, particularly the print station 120 and/or the inspection station 130. According to embodiments, once the substrate 150 is aligned, the common axis 160 can move the substrate 150 to any position along the common axis such that the position of the substrate 150 is known in relation to the apparatus 100 or components of the apparatus 100.

According to embodiments, the common axis 160 includes the stator of a linear motor, particularly a high precision linear motor. The linear motor can be configured for moving the substrate 150 along the common axis 160. The linear motor can be a linear induction motor. The linear motor can be a synchronous linear motor. The linear motor can be a piezoelectric linear motor. The linear motor can be a linear stepper motor. Further linear motor technologies can be employed. Combinations of linear motor technologies can be employed. According to embodiments, the apparatus 100 can include a substrate holder. The substrate holder can include a reaction plate for engaging with the stator of the linear motor, the reaction plate including, e.g., a set of magnets, permanent magnets, coils, latching structures, or such. The reaction plate can be a structure for engaging with the linear motor to be propelled by the linear motor. The substrate holder can include further actuators for moving, such as rotating or translating, the substrate along further axes other than the common axis 160, e.g. for aligning or aiding in aligning the substrate.

According to embodiments, as shown in Fig. 1, the common axis can be a straight line. According to further embodiments, the common axis can have further shapes, such as provided by including angled portions or curved portions within the common axis. A nonlinear arrangement of the common axis can beneficially reduce the floorspace the apparatus 100.

Referring now to Fig. 2, according to embodiments, an apparatus 200 for printing on a substrate for display manufacture is shown. The apparatus 200 includes several of the features of apparatus 100. The apparatus 200 differs from the apparatus 100 in that a further processing station 222 is provided along the common axis 160 in between the print station 120 and the inspection station 130.

According to embodiments, the processing station 222 can be a secondary print station provided in addition to the print station 120. According to an example, the print station 120 can dispense a first ink onto defined locations on the substrate 150, and the secondary print station can dispense a second ink onto defined locations on the substrate 150. In the example, the first ink can be a first color ink and the second ink can be a second color ink. The secondary print station can provide redundancy, e.g. in case the print station 120 fails.

According to embodiments, the processing station 222 can be a curing station for curing the substrate 150 after printing. Curing the substrate 150 can include providing radiation, such as light or heat, particularly UV light, to the substrate 150 to cure the ink printed onto the substrate 150 in print station 120.

According to embodiments, the processing station 222 can be a component of a reworking process, such as a cleaning and/or bleaching station for cleaning or bleaching the substrate 150 or defined locations on the substrate 150, e.g. when a defect has been detected in inspection station 130.

According to embodiments, the processing station 222 can be a combination of processing stations, such as several secondary print stations, a print station and a curing station, or such. According to embodiments, the processing station 222 can be an optional processing station, i.e. the operation of the processing station 222 can be optional or unrelated to the printing process described herein.

According to embodiments, as shown in Fig. 2, the apparatus 200 is configured for transferring the substrate 150 from the print station 120 to the processing station 222. According to Fig. 2, the transfer of the substrate 150 to the processing station 222 is depicted as transfer 240. According to the embodiment, the apparatus 200 is further configured for transferring the substrate 150 from the processing station 222 to the inspection station 130. According to Fig. 2, the transfer of the substrate 150 from the processing station to the inspection station is depicted as transfer 242. According to the embodiment, the transfer of the substrate 150 is performed by the common axis 160 configured for transferring the substrate 150.

According to embodiments, as shown in Fig. 2, the apparatus 200 is configured for transferring the substrate 150 from the inspection station 130 back to the print station 120, particularly by first transferring the substrate 150 to the processing station 222 and subsequently transferring the substrate 150 from the processing station 222, i.e. through the processing station 222, to the print station 120. According to Fig. 2, the transfer of the substrate 150 from the inspection station 130 back to the print station is depicted as transfer 244 and transfer 246. The transfer of the substrate 150 can be performed by the common axis 160 configured for transferring the substrate 150. The transfers 244 and 246 can be conditional, i.e. be performed when defects are detected in inspection station 130.

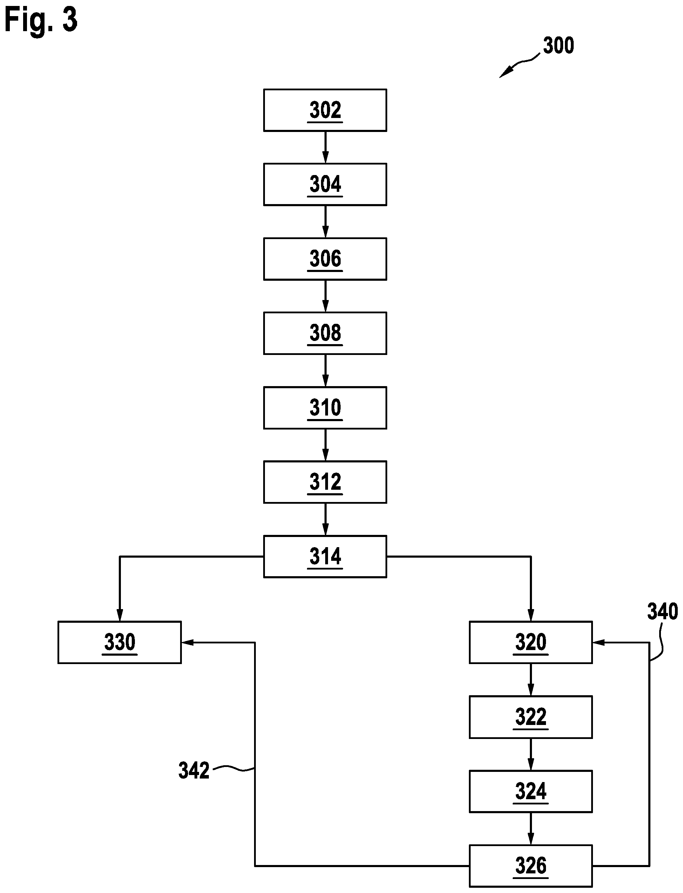

Referring now to Fig. 3, according to embodiments, a method 300 for printing on a substrate for display manufacture is provided. The method can be performed according to operations disclosed herein, particularly operations as carried out by embodiments discussed in relation to an apparatus as discussed in relation to Fig. 1 and/or Fig. 2. The method includes loading 302 the substrate into a loading position provided along a common axis, moving 304 the substrate along the common axis from the loading position to an alignment station provided along the common axis, aligning 306 the substrate, moving 308 the substrate along the common axis from the alignment station to a print station provided along the common axis, printing 310 on the substrate, moving 312 the printed substrate along the common axis from the print station to an inspection station provided along the common axis, and inspecting 314 the printed substrate. The method further includes, under the condition that a defect is detected on the printed substrate, performing the following four operations: moving 320 the defective printed substrate back along the common axis from the inspection station to the print station, reworking 322 the defective printed substrate to correct the detected defect by again printing on the substrate in the print station, moving 324 the defective printed substrate along the common axis from the print station to the inspection station, and inspecting 326 the reworked printed substrate. Under the condition that no defect is detected on the printed substrate, the method includes moving 330 the printed substrate along the common axis from the inspection station for further processing.

According to embodiments, the aligning 306 can be performed in an alignment station, such as the alignment station 110. According to embodiments, the printing 310 can be performed in a print station, such as the print station 120. According to embodiments, the inspecting 314 can be performed in an inspection station, such as the inspection station 130. According to embodiments, moving operations, such as moving operations 304, 308, 312, 320, 324, 330 and/or 342 can be performed by or include the operation of a common axis, such as common axis 160. According to embodiments, the method can include further operations, such as an operation performed by a processing station 222. According to embodiments, the operations of the method can be performed in alternative sequences or combinations of operations, e.g. aligning 306 the substrate can include an aligned printing 310 onto the substrate, e.g. printing 310 according to an identified position of the substrate.

According to embodiments, as shown in Fig. 3, the method can include repeating the reworking 340, particularly in cases where an inspection following a first reworking shows defects. Repeating the reworking can include performing any of the operations 320 through 326.

According to embodiments, as shown in Fig. 3, the method can include enabling further processing 342, particularly in cases where, after reworking 322 and inspecting 326 the substrate, no further defects are detected on the substrate.

According to embodiments, a print station as disclosed herein, such as the print station 120 or a station for performing the printing 310, can include a print head, such as one or more print heads, for printing an ink on the substrate. Possible print heads include a dispensing print head, a laser transfer print head, or particularly an ink jet print head. The ink jet print head can be a ceramic ink jet print head suitable for high-volume applications. The ink jet print head can be a piezo-actuated print head. The ink jet print head can be suitable for dispensing droplets of ink with a volume of 6 - 42 picoliters, particularly droplets of ink with a volume of 1 - 10 picoliters. The print head can print an ink as described above, particularly a curable ink, particularly an ink including a fluorescent dye, such as a quantum dot dye.

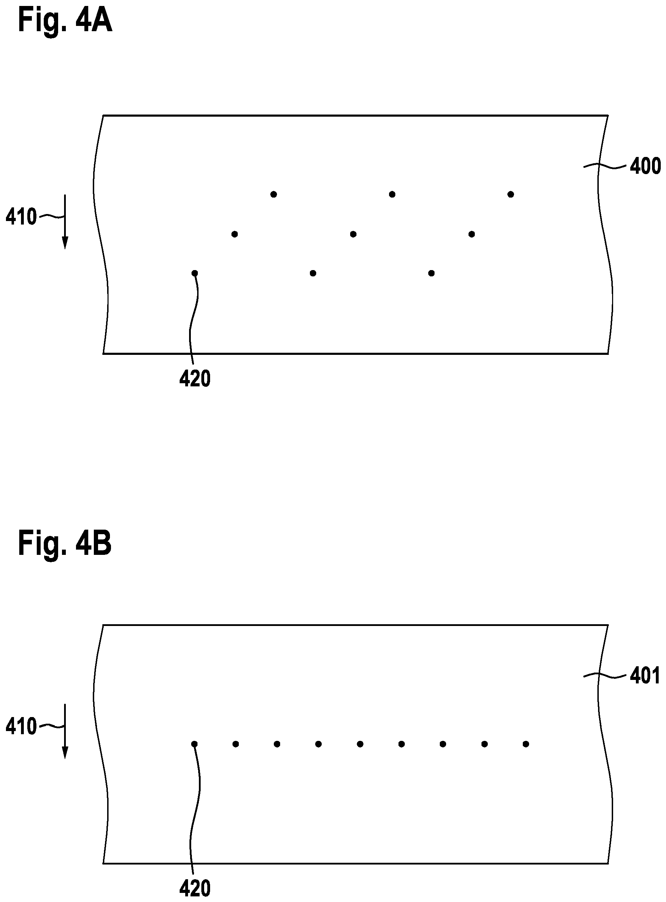

Referring now to Fig. 4A, a conventional ink jet print head 400 is described as an example, with Fig. 4A depicting a section of the surface of the print head 400 opposite a substrate to be printed on. The print head can be a commercially available print head, such as a Xaar 1003 print head. The print head 400 has a number of nozzles 420 for dispensing an ink, particularly in the form of droplets. Nine nozzles 420 are shown in Fig. 4A, however only one nozzle has been denoted with the reference numeral to increase the visibility of the figure. A typical relative direction of movement of the substrate 410 is depicted. As shown in Fig. 4A, the nozzles of the conventional print head are arranged in a staggered fashion relative to the direction of movement of the substrate 410. When printing, the conventional print head 400 is typically operated such that the nozzles dispense the ink in a timed manner according to the stagger and the speed of the substrate, typically negating the effect of the staggered nozzle arrangement when the substrate is printed on while moved strictly parallel to the direction along which the nozzles are staggered. However, if the substrate is provided for printing on at an angle relative to the print head, i.e. a direction that is not strictly parallel to the direction along which the nozzles are staggered, the spacing between the nozzles becomes uneven. This often excludes most or all of such printing angles when a uniform spacing between nozzles or positions to be printed on with ink dispensed from the nozzles is desired.

Referring now to Fig. 4B, a print head 401 according to embodiments is shown. The print head 401 includes several of the features of the conventional print head 400. The print head 401 differs from the conventional print head 400 in that the nozzles 420 are arranged in a straight line, particularly in a non-staggered arrangement, an example for a staggered arrangement being described in relation to the conventional print head 400. The nozzles being arranged in a straight line can be defined as the nozzles 420 having a maximum stagger, offset or placement error in the direction perpendicular to the direction of the line of nozzles. The maximum stagger, offset or placement error can be defined as being less than 10 % of the spacing between the nozzles, such as less than 5 %, less than 2 %, less than 1 % or less than 0.1 %.

According to embodiments, as shown in Fig. 4B, the nozzles 420 can be evenly spaced or uniform, i.e. the distance between adjacent nozzles can be equal or effectively equal. The spacing of the nozzles can define a resolution of the line of nozzles 420 and/or the print head 401. The print head 401 can have a plurality of nozzles with a spacing of at least 150 nozzles per inch (npi), such as 150 - 160 npi or more than 160 npi. The print head can have a plurality of nozzles arranged in a straight line, the plurality of nozzles arranged in the straight line including at least 250 nozzles, at least 300 nozzles, 300 to 500 nozzles or at least 500 nozzles. In addition to having one line of nozzles, the print head 401 can include multiple pluralities of nozzles arranged in a straight line, such as two lines of nozzles, three lines of nozzles, or more than three lines of nozzles. The multiple pluralities of nozzles arranged in a straight line can be two lines of nozzles, particularly two parallel lines of nozzles, particularly two parallel lines of nozzles spaced apart along the direction of movement of the substrate 410.

According to embodiments, the print head 401 is configured for providing a single droplet of ink onto each desired position on the substrate. Accordingly, it is desirable that the position of the nozzles to provide the ink onto the substrate is aligned along the direction of movement of the substrate 410, with the desired locations on the substrate. The print head 401 can have a spacing of the nozzles 420 as described above. According to some embodiments, the spacing of the nozzles can be lower than the desired spacing for the printing process to selectively print on the substrate, e.g. the spacing of desired locations on the substrate can be n locations per inch along the direction perpendicular to the direction of movement of the substrate 410, and the print head can have a native spacing of $m$ nozzles per inch, with $n > m$. The spacing of the nozzles can be modified by providing the print head, i.e. the line of nozzles included in the print head, at an angle, with the spacing $m_i$ being dependent on the angle $\alpha$ and the native spacing $m$ of the print head according to

$$m_i = m \cdot sin\, \alpha^{-1}$$

According to embodiments, the nozzles 420 of the print head 401 are arranged along a straight line, thus, the spacing of the nozzles 420 remains uniform as described above, particularly also when provided at an angle. According to embodiments, an angle $\alpha$ can be chosen for the print head 401 such that the spacing of the nozzles 420 of the angled print head perpendicular to the direction of movement of the substrate 410 corresponds to the spacing of desired locations to be printed onto the substrate.

According to embodiments, the print head 401 can be provided at an angle between 0° and 90°, with the angle 90° corresponding to the arrangement as shown in Fig. 4B with the line of nozzles extending perpendicular to the direction of the movement of the substrate, and the angle of 0° corresponding to the line of nozzles extending in parallel to the direction of the movement of the substrate. Further beneficial embodiments include providing the print head at an angle of 10° - 90°, or 20° - 90°, particularly 30° to 90°, 35° to 90° or 40° to 90°.

Benefits of embodiments include the ability to provide a higher printing resolution with a lower-resolution print head, and a higher flexibility for printing on different substrates, particularly substrates with different feature resolutions, without having to exchange print heads between substrate batches including different resolution substrates.

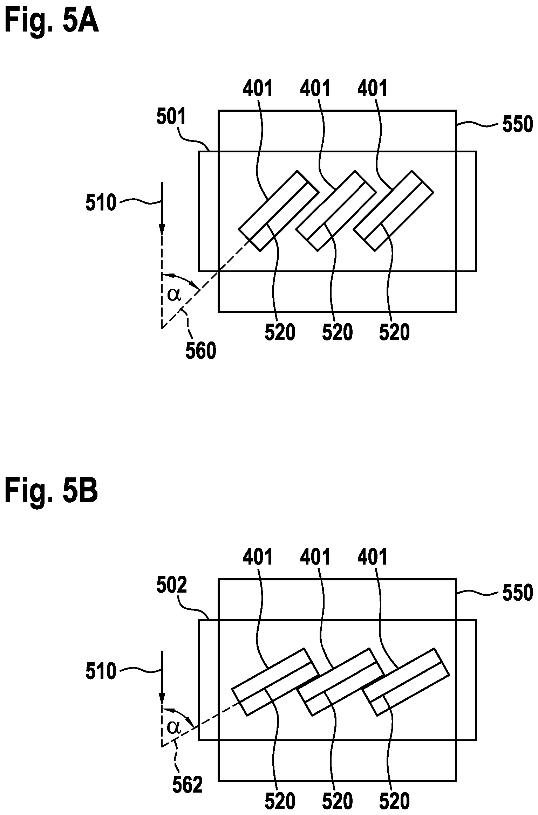

Referring now to Figs. 5A-B, according to embodiments, a number of arrangements of print heads 401 provided within print bars 501, 502, 503 and 504 is shown in a top-down view onto the surface of a substrate 550.

The print bars can be arranged on or inside a print station, such as print station 120 or a station for printing 310. The print heads 401 can be print heads according to embodiments described herein. The print heads 401 can be provided stationary within the print station 120 during printing of the substrate 550. Particularly, the print station 120 can be configured for not requiring a movement of the print heads relative to the print station during printing. The print bar 501, 502, 503 and 504 can include a number of print heads 401, such as one print head, two print heads, three print heads, 4 print heads, 5 to 8 print heads or 5 to 10 print heads. Increasing the number of print heads can increase the maximum printable size and/or size of a substrate 550 to be printed, particularly the maximum width of the substrate 550 along the direction perpendicular to the direction of movement of the substrate 510.

According to embodiments, as shown in Figs. 5A-B, the substrate 550 can be larger than the maximum printable size, however, it can be beneficial if the maximum printable size is equal or larger than the substrate width, particularly if the whole area of the substrate is to be printed.

According to embodiments, as shown in Figs. 5A-B, the substrate 550 has a direction of movement 510 through the print station including the print bar 501, 502, 503 or 504. According to embodiments, the movement can be provided by moving the substrate on the common axis, particularly with or by the common axis. The print bar 501, 502, 503 or 504 can be arranged inside the print station. The print bar 501, 502, 503 or 504 can be provided inside the print station in a fixed position, particularly during a printing operation for printing on the substrate 550.

According to embodiments, the print bar 501, 502, 503 or 504 can include actuators for modifying a position of the print bar 501, 502, 503 or 504, particularly relative to a position of the substrate 550, such as an identified position provided by the alignment station 110. Modifying the position can include translating or rotating the print bar 501, 502, 503 or 504 relative to the substrate 550. Modifying the position can align the print station 120, particularly align the print station 120 relative to the substrate 550, such as according to an identified position of the substrate provided, e.g., by the alignment station 110. In the context of this disclosure, aligning the print station, particularly components of the print station such as the print head 501, 502, 503 or 504, relative to the substrate can be understood as aligning the substrate.

According to embodiments, as shown in Figs. 5A-B, the print heads 401 can be arranged inside the print bar 501, 502, 503 or 504 at different angles, such that the angle of the line of nozzles 520 is arranged at an angle 560, 562, 564 or 566 relative to the direction of movement of the substrate 510. The print heads can be arranged at an angle for the reasons described above, particularly when the desired spacing of features on the substrate 550 does not correspond with the native spacing of the nozzles in the print heads 401.

According to embodiments, as shown in Fig. 5A, the print bar 501 can include print heads 401 arranged such that the angle 560 of the line of nozzles 520 relative to the direction of movement of the substrate is 45°. Further angles 562 as in FIG. 5B can be possible, such as the range of angles described above. According to embodiments, care is taken that there is an overlap or no gap between the outermost positions of the lines of nozzles 520 between print heads 401 along the direction perpendicular to the direction of movement of the substrate 410, such that every position or desired location of the substrate can be printed.

According to embodiments, as shown in Fig. 5B, the print bar 502 can include print heads 401 arranged such that the angle 562 of the line of nozzles 520 relative to the direction of movement of the substrate is 60°. Further angles 562 can be possible, such as the range of angles described above. According to embodiments, the print bar 502 can be the print bar 501 in a second arrangement. According to embodiments, the print heads 401 provided within print bars 501 and/or 502 can be arranged such that the angle 560, 562 of the print heads is adjustable. The angle 560, 562 can be adjustable by providing actuators for actuating the print heads 401. The angle 560, 562 can be adjustable according to desired properties of the print station, such as the desired spacing of nozzles relative to the direction of movement of the substrate 510, such as described above.

According to an embodiment, as shown in Fig. 5A and Fig. 5B, the print bar 501, 502 can be configured for rotating the print heads 401 arranged therein. In the shown embodiment, the print bar can remain stationary within the print station 120 and the print heads can be rotated within the print bar 501, 502 to adjust the angle 560, 562 of the print head relative to the direction of movement of the substrate 510.

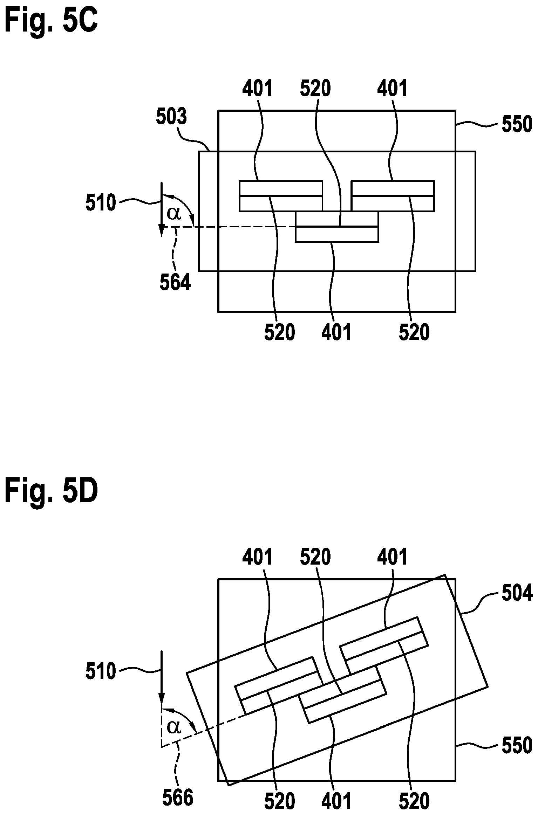

According to embodiments, as shown in Fig. 5C, the print bar 503 can include print heads 401 arranged such that the angle 564 of the line of nozzles 520 relative to the direction of movement of the substrate 410 is 90°. Further angles 562 can be possible, such as the range of angles described above. Accordingly, the spacing of the nozzles in the line of nozzles 520 corresponds to the available spacing of locations onto which ink can be dispensed by the nozzles. According to embodiments, care is taken that there is an overlap or no gap between the outermost positions of the lines of nozzles 520 between print heads 401 along the direction perpendicular to the direction of movement of the substrate 410, such that every position or desired location of the substrate can be printed. In contrast to the embodiments of Fig. 5A or Fig. 5B, the print heads 401 of print bar 503 are not arranged along a single line or direction, but provided in two lines of print heads, the two lines of print heads being offset along a direction that can be the direction of movement of the substrate 510. Further arrangements of print heads within the print bars 501, 502, 503 or 504 are possible, such as more than two lines of print heads, or a combination of staggered print heads and print heads provided at different angles within the print bar.

According to embodiments, as shown in Fig. 5D, the print bar 504 can be provided at an angle, such that the angle 566 of the line of nozzles 520 relative to the direction of movement of the substrate 410 is 70°. Further angles 566 can be possible, such as the range of angles described above. According to embodiments, the print bar 504 can be the print bar 503 in a second arrangement or provided at an alternative angle. According to embodiments, the print heads 401 provided within print bars 503 and/or 504 can be arranged such that the angle 564, 566 of the print heads within the print bar remains static. According to embodiments, the print bar 503, 504 can be arranged so that the print bar can be rotated in relation to the direction of movement of the substrate 510 to adjust the angle 560, 562. The angle 560, 562 can be adjustable by providing actuators for actuating, i.e. rotating the print bar. The angle 560, 562 can be adjustable according to desired properties of the print station, such as the desired spacing of nozzles relative to the direction of movement of the substrate 510, such as described above.

Benefits of embodiments relating to the print station, particularly embodiments relating to print heads and/or print bars including print heads, can be a high flexibility of printing, particularly the printing of substrates for display manufacture, particularly the printing onto substrates having differently sized or spaced features or desired printing locations corresponding to the features.

Benefits of embodiments described herein can include effects of the ability of the apparatus or method to perform a printing process and, if desired, a subsequent reworking process on a substrate within a single manufacturing process or manufacturing line. This can improve the manufacturing speed and productivity, and reduce the cost and labor and eliminate the need for additional manufacturing tools, such as separate reworking stations. Furthermore, the overall quality of printed substrates and display devices based thereon can be improved without significantly increasing the number of rejected or defective substrates, thereby allowing the manufacture of larger or higher resolution printed substrates.

**Claims**

1. An apparatus (100, 200) for printing on a substrate (150) for display manufacture, comprising:

   an alignment station (110) for aligning the substrate (150);
   a print station (120) for printing on the substrate (150); and
   an inspection station (130) for inspecting the printed substrate (150) for defects, wherein

   the alignment station (110), the print station (120) and the inspection station (130) are provided along a common axis (160),
   the common axis (160) is configured for moving the substrate (150) from the alignment station (110) to the print station (120) and from the print station (120) to the inspection station (130),
   the common axis (160) is further configured for moving the printed substrate (150), under the condition that a defect is detected in the inspection station (130), from the inspection station (130) back to the print station (120), and wherein

   the print station (120) is configured for reworking the printed substrate (150) to correct the detected defect by again printing on the substrate (150).

2. The apparatus (100, 200) according to claim 1, wherein the common axis (160) comprises a stator of a linear motor.

3. The apparatus (100, 200) according to claim 1 or 2, wherein

   the apparatus comprises a substrate holder, and wherein
   the substrate holder includes a reaction plate for engaging with a stator of a linear motor.

4. The apparatus (100, 200) according to any of the preceding claims, wherein the alignment station (110) is configured for aligning the substrate (150) according to at least one of the following:

   fiducial markers provided on the substrate (150) and/or a substrate holder;
   an edge position of the substrate (150); and
   a position of features comprising a pixel structure provided on the substrate (150).

5. The apparatus (100, 200) according to any of the preceding claims, wherein the print station (120) comprises a print head (401) for printing an ink on the substrate (150).

6. The apparatus (100, 200) according to claim 5, wherein the ink comprises a fluorescent dye, including a UV-excitable fluorescent quantum dot dye.

7. The apparatus (100, 200) according to any of the claims 5 or 6, wherein the print head (401) comprises a plurality of nozzles (420) for dispensing the ink, and wherein the plurality of nozzles (420) is arranged along a straight line, particularly wherein

the print head (401) comprises a plurality of nozzles (420) with a spacing of at least 150 nozzles per inch or 2.54 cm, and/or particularly wherein

the print head (401) comprises a plurality of nozzles (420) with at least 250 nozzles per line.

8. The apparatus (100, 200) according to any of the preceding claims, wherein:

the print station (120) comprises a print bar; the print bar comprises at least one print head (401) according to any of the claims 5 to 7; the at least one print head (401) is arranged such that the line of nozzles (420) of the at least one print head (401) is provided at an angle (560, 562) relative to the direction (510) of movement of the substrate (150) through the print station (120); and the angle (560, 562) of the line of nozzles (420) of the at least one print head (401) relative to the direction (510) of movement of the substrate (150) through the print station (120) is between 0° and 90°.

9. The apparatus (100, 200) according to the preceding claim, wherein the print head (401) is arranged such that the angle (560, 562) of the print head (401) relative to the direction (510) of movement of the substrate (150) through the print station (120) is adjustable.

10. The apparatus (100, 200) according to any of the claims 5 to 9, wherein the print head (401) is provided stationary within the print station (120) during printing.

11. The apparatus (100, 200) according to any of the preceding claims, wherein the inspection station (130) comprises a visual inspection system, including a camera-based visual inspection system.

12. The apparatus (100, 200) according to any of the preceding claims, further including a curing station configured for curing the substrate (150), wherein the common axis (160) is configured for moving the substrate (150) from the print station (120) to the curing station and from the curing station to the inspection station (130).

13. A method (300) for printing on a substrate (150) for display manufacture, the method comprising:

loading (302) the substrate (150) into a loading position provided along a common axis (160); moving (304) the substrate (150) along the common axis (160) from the loading position to an alignment station (110) provided along the common axis (160); aligning (306) the substrate (150); moving (308) the substrate (150) along the common axis (160) from the alignment station (110) to a print station (120) provided along the common axis (160); printing (310) on the substrate (150); moving (312) the printed substrate (150) along the common axis (160) from the print station (120) to an inspection station (130) provided along the common axis (160); inspecting (314) the printed substrate (150); under the condition that a defect is detected on the printed substrate (150), performing operations a.) through d.):

a.) moving (320) the defective printed substrate (150) back along the common axis (160) from the inspection station (130) to the print station (120); b.) reworking (322) the defective printed substrate (150) to correct the detected defect by again printing on the substrate in the print station (120); c.) moving (324) the defective printed substrate (150) along the common axis (160) from the print station (120) to the inspection station (130); and d.) inspecting (326) the reworked printed substrate (150); and

under the condition that no defect is detected on the printed substrate (150), moving (330) the printed substrate (150) along the common axis (160) from the inspection station (130) for further processing.

14. The method according to claim 13, wherein:

the substrate (150) is configured for providing a plurality of micro LEDs for specifically illuminating a location of the substrate (150); and a selection of the plurality of micro LEDs comprises a pixel of a display.

15. The method according to claim 13 or 14, wherein:

the print station (120) is configured for selectively printing an ink onto a plurality of locations on the substrate (150); and the ink is configured for forming, when illuminated by a micro LED, a component of a pixel of a display device.

**Patentansprüche**

1. Vorrichtung (100, 200) zum Bedrucken eines Substrats (150) für die Displayherstellung, umfassend:

> eine Ausrichtstation (110) zum Ausrichten des Substrats (150);
> eine Druckstation (120) zum Bedrucken des Substrats (150); und
> eine Inspektionsstation (130) zum Prüfen des bedruckten Substrats (150) auf Defekte, wobei die Ausrichtstation (110), die Druckstation (120) und die Inspektionsstation (130) entlang einer gemeinsamen Achse (160) vorgesehen sind,
> die gemeinsame Achse (160) dazu ausgelegt ist, das Substrat (150) von der Ausrichtstation (110) zur Druckstation (120) und von der Druckstation (120) zur Inspektionsstation (130) zu bewegen,
> die gemeinsame Achse (160) ferner dazu ausgelegt ist, das bedruckte Substrat (150) unter der Bedingung, dass in der Inspektionsstation (130) ein Defekt detektiert wird, von der Inspektionsstation (130) zurück zur Druckstation (120) zu bewegen, und wobei
> die Druckstation (120) dazu ausgelegt ist, das bedruckte Substrat (150) nachzubearbeiten, um den detektierten Defekt durch erneutes Bedrucken des Substrats (150) zu korrigieren.

2. Vorrichtung (100, 200) nach Anspruch 1, wobei die gemeinsame Achse (160) einen Stator eines Linearmotors umfasst.

3. Vorrichtung (100, 200) nach Anspruch 1 oder 2, wobei

> die Vorrichtung einen Substrathalter umfasst, und wobei
> der Substrathalter eine Reaktionsplatte zum Eingriff mit einem Stator eines Linearmotors aufweist.

4. Vorrichtung (100, 200) nach einem der vorstehenden Ansprüche, wobei die Ausrichtstation (110) so konfiguriert ist, dass sie das Substrat (150) gemäß mindestens einem von Folgendem ausrichtet:

> Referenzmarken, die auf dem Substrat (150) und/oder einem Substrathalter vorgesehen sind;
> eine Kantenposition des Substrats (150); und
> eine Position von Merkmalen, die eine auf dem Substrat (150) vorgesehene Pixelstruktur umfassen.

5. Vorrichtung (100, 200) gemäß einem der vorstehenden Ansprüche, wobei die Druckstation (120) einen Druckkopf (401) zum Aufbringen einer Tinte auf das Substrat (150) umfasst.

6. Vorrichtung (100, 200) nach Anspruch 5, wobei die Tinte einen fluoreszierenden Marker umfasst, umfassend einen UV-anregbaren fluoreszierenden Quantenpunkt-Marker.

7. Vorrichtung (100, 200) nach einem der Ansprüche 5 oder 6, wobei der Druckkopf (401) eine Vielzahl von Düsen (420) zum Ausbringen der Tinte umfasst, und wobei die Vielzahl von Düsen (420) entlang einer geraden Linie angeordnet ist, insbesondere wobei

> der Druckkopf (401) eine Vielzahl von Düsen (420) mit einem Abstand von mindestens 150 Düsen pro Zoll oder 2,54 cm umfasst, und/oder insbesondere wobei
> der Druckkopf (401) eine Vielzahl von Düsen (420) mit mindestens 250 Düsen pro Zeile umfasst.

8. Vorrichtung (100, 200) nach einem der vorstehenden Ansprüche, wobei:

> die Druckstation (120) eine Druckleiste umfasst;
> die Druckleiste mindestens einen Druckkopf (401) nach einem der Ansprüche 5 bis 7 umfasst;
> der mindestens eine Druckkopf (401) so angeordnet ist, dass die Düsenreihe (420) des mindestens einen Druckkopfs (401) in einem Winkel (560, 562) relativ zur Bewegungsrichtung (510) des Substrats (150) durch die Druckstation (120) verläuft; und
> der Winkel (560, 562) der Düsenreihe (420) des mindestens einen Druckkopfes (401) relativ zur Bewegungsrichtung (510) des Substrats (150) durch die Druckstation (120) liegt zwischen 0° und 90°.

9. Vorrichtung (100, 200) nach dem vorstehenden Anspruch, wobei der Druckkopf (401) derart angeordnet ist, dass der Winkel (560, 562) des Druckkopfs (401) relativ zur Bewegungsrichtung (510) des Substrats (150) durch die Druckstation (120) einstellbar ist.

10. Vorrichtung (100, 200) nach einem der Ansprüche 5 bis 9, wobei der Druckkopf (401) während des Druckvorgangs stationär innerhalb der Druckstation (120) angeordnet ist.

11. Vorrichtung (100, 200) nach einem der vorstehenden Ansprüche, wobei die Inspektionsstation (130) ein visuelles Inspektionssystem umfasst, umfassend ein kamerabasiertes visuelles Inspektionssystem.

12. Vorrichtung (100, 200) nach einem der vorstehenden Ansprüche, die ferner eine Aushärtungsstation umfasst, die zum Aushärten des Substrats (150) ausgelegt ist, wobei

die gemeinsame Achse (160) konfiguriert ist, das Substrat (150) von der Druckstation (120) zur Aushärtungsstation und von der Aushärtungsstation zur Inspektionsstation (130) zu bewegen.

13. Verfahren (300) zum Bedrucken eines Substrats (150) für die Herstellung von Displays, wobei das Verfahren umfasst:

Einlegen (302) des Substrats (150) in eine entlang einer gemeinsamen Achse (160) vorgesehene Einlegeposition;

Bewegen (304) des Substrats (150) entlang der gemeinsamen Achse (160) von der Ladeposition zu einer Ausrichtstation (110), die entlang der gemeinsamen Achse (160) vorgesehen ist;

Ausrichten (306) des Substrats (150);

Bewegen (308) des Substrats (150) entlang der gemeinsamen Achse (160) von der Ausrichtstation (110) zu einer entlang der gemeinsamen Achse (160) vorgesehenen Druckstation (120);

Bedrucken (310) des Substrats (150);

Bewegen (312) des bedruckten Substrats (150) entlang der gemeinsamen Achse (160) von der Druckstation (120) zu einer entlang der gemeinsamen Achse (160) vorgesehenen Inspektionsstation (130);

Prüfen (314) des bedruckten Substrats (150); unter der Bedingung, dass ein Defekt auf dem bedruckten Substrat (150) detektiert wird, Durchführung der Schritte a.) bis d.):

a.) Bewegen (320) des defekten bedruckten Substrats (150) entlang der gemeinsamen Achse (160) von der Inspektionsstation (130) zurück zur Druckstation (120);

b.) Nachbearbeiten (322) des defekten bedruckten Substrats (150), um den detektierten Defekt zu korrigieren, indem das Substrat in der Druckstation (120) erneut bedruckt wird;

c.) Bewegen (324) des defekten bedruckten Substrats (150) entlang der gemeinsamen Achse (160) von der Druckstation (120) zur Inspektionsstation (130); und

d.) Prüfen (326) des nachbearbeiteten bedruckten Substrats (150); und

unter der Bedingung, dass kein Defekt auf dem bedruckten Substrat (150) detektiert wird, Bewegen (330) des bedruckten Substrats (150) entlang der gemeinsamen Achse (160) von der Inspektionsstation (130) zur weiteren Verarbeitung.

14. Verfahren nach Anspruch 13, wobei:

das Substrat (150) so konfiguriert ist, dass es eine Vielzahl von Mikro-LEDs bereitstellt, um eine Stelle des Substrats (150) gezielt zu beleuchten; und

eine Auswahl aus der Vielzahl von Mikro-LEDs ein Pixel eines Displays bildet.

15. Verfahren nach Anspruch 13 oder 14, wobei:

die Druckstation (120) so konfiguriert ist, dass sie selektiv eine Tinte auf eine Vielzahl von Stellen auf dem Substrat (150) druckt; und die Tinte so konfiguriert ist, dass sie, wenn sie von einer Mikro-LED beleuchtet wird, einen Bestandteil eines Pixels einer Displayvorrichtung bildet.

**Revendications**

1. Appareil (100, 200) d'impression sur un substrat (150) pour la fabrication d'un dispositif d'affichage, comprenant :

un poste d'alignement (110) destiné à aligner le substrat (150) ;

un poste d'impression (120) destiné à imprimer sur le substrat (150) ; et

un poste d'inspection (130) destiné à inspecter le substrat imprimé (150) par rapport à des défauts, dans lequel

le poste d'alignement (110), le poste d'impression (120) et le poste d'inspection (130) sont disposés le long d'un axe commun (160),

l'axe commun (160) est configuré pour déplacer le substrat (150) du poste d'alignement (110) vers le poste d'impression (120) et du poste d'impression (120) vers le poste d'inspection (130),

l'axe commun (160) est en outre configuré pour déplacer le substrat imprimé (150), à la condition qu'un défaut soit détecté dans le poste d'inspection (130), du poste d'inspection (130) en retour vers le poste d'impression (120), et dans lequel

le poste d'impression (120) est configuré pour retravailler le substrat imprimé (150) pour corriger le défaut détecté par une nouvelle impression sur le substrat (150).

2. Appareil (100, 200) selon la revendication 1, dans lequel l'axe commun (160) comprend un stator d'un moteur linéaire.

3. Appareil (100, 200) selon la revendication 1 ou la revendication 2, dans lequel

l'appareil comprend un porte-substrat, et dans lequel
le porte-substrat comprend un plateau de réaction destinée à coopérer avec un stator d'un moteur linéaire.

4. Appareil (100, 200) selon l'une quelconque des revendications précédentes, dans lequel le poste d'alignement (110) est configuré pour aligner le substrat (150) conformément à au moins les uns des éléments suivants :

des repères de référence disposés sur le substrat (150) et/ou sur le porte-substrat ;
une position de bord du substrat (150) ; et
une position de caractéristiques comprenant une structure de pixel disposée sur le substrat (150).

5. Appareil (100, 200) selon l'une quelconque des revendications précédentes, dans lequel le poste d'impression (120) comprend une tête d'impression (401) destinée à imprimer une encre sur le substrat (150).

6. Appareil (100, 200) selon la revendication 5, dans lequel l'encre comprend un colorant fluorescent, comprenant un colorant à points quantiques fluorescents excitables par UV.

7. Appareil (100, 200) selon l'une ou l'autre des revendications 5 et 6, dans lequel la tête d'impression (401) comprend une pluralité de buses (420) destinées à distribuer l'encre, et dans lequel les buses de la pluralité de buses (420) sont disposées le long d'une ligne droite, particulièrement dans lequel

la tête d'impression (401) comprend une pluralité de buses (420) avec un espacement d'au moins 150 buses par pouce ou 2,54 cm, et/ou particulièrement dans lequel
la tête d'impression (401) comprend une pluralité de buses (420) dotée d'au moins 250 buses par ligne.

8. Appareil (100, 200) selon l'une quelconque des revendications précédentes, dans lequel :

le poste d'impression (120) comprend une barre d'impression ;
la barre d'impression comprend au moins une tête d'impression (401) selon l'une quelconque des revendications 5 à 7 ;
l'au moins une tête d'impression (401) est disposée de sorte que la ligne de buses (420) de l'au moins une tête d'impression (401) est disposée à un angle (560, 562) par rapport au sens (510) de déplacement du substrat (150) à travers le poste d'impression (120) ; et
l'angle (560, 562) de la ligne de buses (420) de l'au moins une tête d'impression (401) par rapport au sens (510) de déplacement du substrat (150) à travers le poste d'impression (120) est compris entre 0° et 90°.

9. Appareil (100, 200) selon la revendication précédente, dans lequel la tête d'impression (401) est disposée de sorte que l'angle (560, 562) de la tête d'impression (401) par rapport au sens (510) de déplacement du substrat (150) à travers le poste d'impression (120) peut être réglé.

10. Appareil (100, 200) selon l'une quelconque des revendications 5 à 9, dans lequel la tête d'impression (401) est disposée immobile à l'intérieur du poste d'impression (120) pendant l'impression.

11. Appareil (100, 200) selon l'une quelconque des revendications précédentes, dans lequel le poste d'inspection (130) comprend un système d'inspection visuelle, comprenant un système d'inspection visuelle à base de caméra.

12. Appareil (100, 200) selon l'une quelconque des revendications précédentes, comprenant en outre un poste de traitement thermique configuré pour traiter thermiquement le substrat (150), dans lequel l'axe commun (160) est configuré pour déplacer le substrat (150) du poste d'impression (120) vers le poste de traitement thermique et du poste de traitement thermique vers le poste d'inspection (130).

13. Procédé (300) d'impression sur un substrat (150) pour la fabrication d'un dispositif d'affichage, le procédé comprenant les étapes consistant à :

charger (302) le substrat (150) dans une position de chargement disposée le long d'un axe commun (160) ;
déplacer (304) le substrat (150) le long de l'axe commun (160) de la position de chargement vers un poste d'alignement (110) disposé le long de l'axe commun (160) ;
aligner (306) le substrat (150) ;
déplacer (308) le substrat (150) le long de l'axe commun (160) du poste d'alignement (110) vers un poste d'impression (120) disposé le long de l'axe commun (160) ;
imprimer (310) sur le substrat (150) ;
déplacer (312) le substrat imprimé (150) le long de l'axe commun (160) du poste d'impression (120) vers un poste d'inspection (130) disposé le long de l'axe commun (160) ;
inspecter (314) le substrat imprimé (150) ;

à la condition qu'un défaut soit détecté sur le substrat imprimé (150), exécuter des opérations a.) à d.) consistant à :

a.) déplacer (320) le substrat imprimé défectueux (150) en retour le long de l'axe commun (160) du poste d'inspection (130) vers le poste d'impression (120) ;
b.) retravailler (322) le substrat imprimé défectueux (150) pour corriger le défaut détecté par une nouvelle impression sur le substrat dans le poste d'impression (120) ;
c.) déplacer (324) le substrat imprimé défectueux (150) le long de l'axe commun (160) du poste d'impression (120) vers le poste d'inspection (130) ; et
d.) inspecter (326) le substrat imprimé retravaillé (150) ; et

à la condition qu'aucun défaut ne soit détecté sur le substrat imprimé (150), déplacer (330) le substrat imprimé (150) le long de l'axe commun (160) du poste d'inspection (130) à des fins de traitement plus avant.

14. Procédé selon la revendication 13, dans lequel :

le substrat (150) est configuré pour fournir une pluralité de micro DEL destinées à éclairer particulièrement un emplacement du substrat (150) ; et
une sélection de la pluralité de micro DEL comprend un pixel d'un dispositif d'affichage.

15. Procédé selon la revendication 13 ou la revendication 14, dans lequel :

le poste d'impression (120) est configuré pour imprimer sélectivement une encre sur une pluralité d'emplacements sur le substrat (150) ; et
l'encre est configurée pour former, lorsqu'elle est éclairée par une micro DEL, un composant d'un pixel d'un dispositif d'affichage.

# Fig. 1

100

150

140

110

120

130

146

148

142

144

160

# Fig. 2

200

140    150

110

120

222

130

246    244

148

142    240    242    160

**Fig. 3**

300

```
┌──────────┐
│   302    │
└────┬─────┘
     │
     ▼
┌──────────┐
│   304    │
└────┬─────┘
     │
     ▼
┌──────────┐
│   306    │
└────┬─────┘
     │
     ▼
┌──────────┐
│   308    │
└────┬─────┘
     │
     ▼
┌──────────┐
│   310    │
└────┬─────┘
     │
     ▼
┌──────────┐
│   312    │
└────┬─────┘
     │
     ▼
┌──────────┐
│   314    │
└──────────┘
```

330          320          340

322

324

342          326

## Fig. 4A

400

410

420

## Fig. 4B

401

410

420

## Fig. 5A

## Fig. 5B

# Fig. 5C

**401**  **520**  **401**

**503**  **550**

**510**  α

**564**

**520**  **401**  **520**

# Fig. 5D

**401**  **520**  **401**

**504**

**510**

**550**

α

**566**  **520**  **401**  **520**

**EP 4 302 340 B1**

**Patent documents cited in the description**

- US 2003189604 A1
- US 2013177698 A1